# EUROPÄISCHE PATENTSCHRIFT

(11) **EP 0 584 839 B1**
(45) Veröffentlichungstag und Bekanntmachung des Hinweises auf die Patenterteilung: **21.08.1996**
(21) Anmeldenummer: 93116790.2
(22) Anmeldetag: 21.12.1987
(51) Int. Cl.: H03J 7/18, H04H 1/00

(54) **Verfahren zum empfangsseitigen Auswerten zusätzlicher Informationen innerhalb eines Rundfunksignals**
Method for the use at the reception end of additional information within a radio signal
Procédé d'utilisation à la réception d'informations additionnelles dans un signal radio

(30) Priorität: 19.12.1986 DE 3643617; 31.07.1987 DE 3725487; 05.06.1987 DE 3718845
(43) Veröffentlichungstag der Anmeldung: 02.03.1994
(62) Teilanmeldung aus: 88900888.4
(73) Patentinhaber: Thomson Consumer Electronics Sales GmbH, 30453 Hannover (DE)
(72) Erfinder: Einsel, Robert, Dipl.-Ing., D-29223 Celle (DE); Scharn, Günter, Ing.-grad., D-31832 Bennigsen (DE); Schwaiger, Karl-Heinz, D-85737 Ismaning (DE)

(56) Entgegenhaltungen:
- DE-A- 3 034 155
- DE-A- 3 222 025
- DE-A- 3 432 848
- DE-A- 3 448 043
- RUNDFUNKTECHNISCHE MITTEILUNGEN, Band 30, Nr. 3, Mai/Juni 1986, Seiten 101-108,München, DE; J. MIELKE et al.: "Radio-Daten-System RDS - gegenwärtigerEntwicklungsstand und Versuchsergebnisse"
- EUROPEAN BROADCASTING UNION, Tech. 3244-E, März 1984, Seiten 1-59, Brüssel, BE;"Specifications of the radio data system RDS for VHF/FM sound broadcasting"

## Beschreibung

Die Erfindung bezieht sich auf ein Verfahren gemäß dem Oberbegriff des Patentanspruchs 1. Die Erfindung bezieht sich auch auf ein Verfahren gemäß dem Oberbegriff des Patentanspruchs 3.

Verfahren der eingangs genannten Art sind beispielsweise in dem Technischen Dokument Doc.Techn. Nr. 3244 der Europäischen Rundfunk-Union beschriebenen. Bei dem dort spezifizierten Radio-Daten-Systems (RDS) ist das übertragen zusätzlicher Informationen, z.B. das übertragen alternativer Frequenzen (AF-Code), insbesondere in Form von in einer Liste zusammengefaßten alternativen Frequenzen, als Inhalt eines auf einen 57 kHz-Hilfsträger aufmodulierten Datenstroms vorgesehen. Diese Information ist sowohl beim mobilen Empfang (z.B. bei Autoradios) - etwa beim Verlassen des Ausstrahlungsbereichs eines Senders - als auch beim stationären Empfang - etwa bei Ausfall oder Störung eines Senders - von Interesse. Bei geeignet ausgebildeten Empfängern mit Speicher lassen sich solche Listen abspeichern und so die Zeit zum Einstellen des Empfängers auf die jeweils optimale Frequenz dieser Liste (z.B. nach optimalen Empfangsbedingungen) reduzieren.

Das RDS-Datensignal umfaßt daneben unter anderem eine sogenannte Programme-Identifikation-Information (PI-Code), wobei mit Hilfe des AF-Code unmittelbar und mit Hilfe des PI-Code mittelbar diejenigen alternativen Sendefrequenzen feststellbar sind, auf welchen das Programmsignal der momentanen Empfangsfrequenz ebenfalls empfangbar ist.

Die empfangsseitige Auswertung der alternativen Sendefrequenzen kann in der Weise erfolgen, daß der Empfänger kurzzeitig nacheinander auf die alternativen Frequenzen für jede alternative Frequenz festgestellt wird. Anschließend werden die Empfangsfeldstärken der alternativen Frequenzen und der momentane Empfangsfrequenzen miteinander verglichen, wobei diejenige Frequenz selektiert und als neue Empfangsfrequenz eingestellt wird, welche die höchste gemessene Empfangsfeldstärke liefert (dies kann natürlich auch die bisher eingestellte Empfangsfrequenz sein).

Dabei zeigt sich jedoch das Problem, daß es Fälle gibt, bei denen die Messung der Empfangsfeldstärke - insbesondere bei Mehrwegeempfang - keine zuverlässige Qualitätsaussage über den Empfang bietet. Bei Mehrwegeempfang sind die durch Signaleinbrüche verursachten Empfangsstörungen von den Umwegen, von der momentanen Signalaussteuerung (die von der Programmart - beispielsweise klassische Musik oder Pop-Musik - bestimmt wird) und beim mobilen Empfang von der Fahrzeuggeschwindigkeit abhängig. Ein Empfangssignal, welches durch Mehrwegeempfang gestört ist, kann trotz einer relativ hohen Empfangsfeldstärke zwischen den Signaleinbrüchen subjektiv als außerordentlich störend empfunden werden, wohingegen ein Empfangssignal, welches lediglich durch Rauschen gestört ist, als wesentlich besser empfunden werden kann.

Im Ergebnis kann die geschilderte Auswahl des bestmöglichen Empfangs eines gewählten Programmsignals dazu führen, daß der Empfang dauernd durch Mehrwegeempfangsstörungen beeinträchtigt ist. Dieses unerwünschte Ergebnis läßt sich dadurch nicht wesentlich ändern, daß - etwa mit Hilfe eines zweiten Tuners im Empfänger - auf die alternativen Frequenzen über einen längeren Meßzeitraum abgestimmt wird und die gemessenen Empfangsfeldstärken integriert werden, da auch bei einer solchen Integration in der Regel die durch Mehrwegeempfang gestörten Empfangssignale eine höhere durchschnittliche Empfangsfeldstärke aufweisen als diejenigen Empfangssignale, welche nur durch Rauschen gestört sind.

Solche Störungen können jedoch nicht nur das Programmsignal beeinträchtigen. Auch die zusätzlichen, beispielsweise im RDS-Datenstrom übertragenen Informationen können in Mitleidenschaft gezogen sein, so daß es empfangsseitig unter Umständen entweder zu langen Wartezeiten bis zum Vorliegen wieder korrekt empfangener RDS-Informationen oder aber zu Fehlinterpretationen kommen kann. Dies fällt im allgemeinen besonders negativ ins Gewicht bei Daten, deren Wiederholzyklus im Datenstrom relativ lang ist.

Ein weiteres Problem bezüglich der Programmsignalqualität hat seine Ursachen in der Sendernetzstruktur in einigen Ländern, insbesondere in solchen Ländern mit einander überlappenden Sendernetzen. Da die von einem Muttersender zentral ausgesendeten digitalen Informationen, etwa eine Liste über Alternative Frequenzen, für den per Ballempfang vom Muttersender gespeisten Tochtersender (z.B. Umsetzer) unter Umständen nicht paßt, müßte sie nach dem Ballempfänger ausgefiltert und durch die für den jeweiligen Tochtersender zutreffende Liste ersetzt werden. Diese Ausfilterung und Neueinspeisung ist mit erhöhtem Auswand verbunden. Hinzu kommt, daß durch die Filterung auch die Qualität des Programmsignals verschlechtert wird.

Es ist daher bereits vorgeschlagen worden (DE-A-34 32 848), von allen Sendern einer Sendergruppe eine Folge von Listen alternativer Frequenzen auszustrahlen, wobei jede dieser Listen an ihrem Anfang die Betriebsfrequenz des der betreffenden Liste zugeordneten Senders erhält, um aus der Folge von Listen die jeweils passende und auf den empfangenen Sender optimierte Liste selektieren zu können.

Ein sicherer Empfang einer solchen Folge von Listen setzt jedoch voraus, daß der nachstehend als "Header" bezeichnete Anfang jeder Liste mit der Betriebsfrequenz des der jeweiligen Liste zugeordneten Senders korrekt empfangen wird. Ist dies nicht der Fall - beispielsweise infolge von Störungen durch Mehrwegeempfang -, so können die auf den Header jeder Liste folgenden alternativen Frequenzen empfangsseitig nicht verwertet werden, und zwar auch dann nicht, wenn sie korrekt empfangen werden, denn es kann keine korrekte Zuordnung zu der betreffenden Betriebsfrequenz erfolgen.

Es wurde daher auch schon vorgeschlagen (Firma Blaupunkt-Werke GmbH, Hildesheim), sämtliche alternativen Frequenzen einer Senderkette - die aus mehreren Sendergruppen (z.B. BR-Nord und BR-Süd) bestehen kann - in Form einer Matrix zu übertragen, wobei zu jedem Sender die zugehörigen alternativen Frequenzen als Matrixnachbarn innerhalb der Matrix gruppiert sind. Dieses sog. "Matrixverfahren" hat jedoch den Nachteil, daß infolge der Gruppierungsvorschrift Nachbarn unvermeidlich sein können, welche in Wirklichkeit gar keine im obigen Sinne alternativen Frequenzen sind, so daß empfangsseitig entsprechende Falschabstimmungen auf solche Nachbarn auftreten können. Darüberhinaus ist das Erstellen und das Ändern einer Matrix außerordentlich kompliziert, wobei unter Umständen eine Neubelegung einer freigewordenen Sendefrequenz nur deshalb nicht möglich sein könnte, weil eine bestehende Matrix eine solche Änderung nicht zuließe.

Der Erfindung liegt demgegenüber die Aufgabe zugrunde, bei den Verfahren der eingangs genannten Art die Empfangsqualität zu verbessern.

Diese Aufgabe wird erfindungsgemäß durch die in Patentanspruch 1 aufgeführten Merkmale gelöst.

Die Erfindung beruht auf der Erkenntnis, daß die Empfangsqualität zum einen dadurch verbessert werden kann, daß die alternativen Frequenzen so übertragen werden, daß sie empfangsseitig sicherer zu den jeweiligen Senderbetriebsfrequenzen zugeordnet werden können. Dies hat den Vorteil, daß der Empfänger dann im Bedarfsfall schneller auf eine einen besseren Empfang bietende alternative Frequenz abgestimmt werden kann. Dies gilt sogar selbst dann, wenn der Empfänger eine nur geringe Speicherkapazität aufweisen sollte.

Die Erfindung beruht weiter auch auf der Erkenntnis, daß die Empfangsqualität dadurch verbessert werden kann, daß für die Beurteilung der Empfangsqualität nicht oder jedenfalls nicht ausschließlich die Empfangsfeldstärke, sondern akustische und/oder Programmsignalverzerrungen verwendet werden. Dies hat den Vorteil, daß solche alternativen Frequenzen, die nur "scheinbar" - nämlich wegen einer höheren Empfangsfeldstärke - einen besseren Empfang bieten, in Wirklichkeit aber vom Benutzer als schlechter empfunden werden, empfangsseitig verworfen werden können.

Liegen die innerhalb des Rundfunksignals übertragenen zusätzlichen Daten wie beim RDS-Datensignal in Form von digitalen Informationen vor, so können als Maß für die Programmsignalverzerrungen die Bitfehler im RDS-Datensignal herangezogen werden. Es hat sich nämlich gezeigt, daß die Bitfehler in dem RDS-Datensignal relativ genau mit den Programmsignalverzerrungen korrelieren, obwohl das Programmsignal im Basisband von 0 bis 53 kHz und das RDS-Datensignal auf einem 57 kHz-Träger mit einem Hub von minimal - 1,2 kHz übertragen werden.

Aufgrund dieser Korrelation läßt sich in Weiterbildung der Erfindung der Umstand ausnutzen, daß Störungen durch Mehrwegeempfang oder Interferenz burstartig auftretende Bitfehler des RDS-Datensignals hervorrufen, wohingegen Störungen durch Rauschen gleichförmig verteilte Bitfehler zur Folge haben. Der Grad aller Störungen läßt sich dabei aus der Blockfehlerrate ableiten, welche völlig unabhängig vom Dateninhalt ermittelt werden kann.

Ausgehend hiervon wird für eine optimale Auswahl der den besten momentanen Empfang ermöglichenden Frequenz ein Tuner des Empfängers nacheinander auf die alternativen Frequenzen sowie auf die eingestellte Empfangsfrequenz in zeitlichen Intervallen abgestimmt. Bei einer etwas komfortableren Empfängerkonzeption ist für eine optimale Auswahl der den besten momentanen Empfang ermöglichenden Frequenz ein zweiter Tuner des Empfängers vorgesehen, der nacheinander auf die alternativen Frequenzen sowie auf die eingestellte Empfangsfrequenz des ersten Tuners in Intervallen von beispielsweise mindestens 2 Sekunden abgestimmt wird.

Während dieser - bei der Empfängerkonzeption mit zwei Tunern relativ langen - Abstimmintervalle werden für das gesamte empfangene RDS-Datensignal (welches außer den alternativen Frequenzen eine Fülle weiterer Informationen enthält) die Bitfehler festgestellt. Anschließend werden die für jede alternative Frequenz und für die momentane Empfangsfrequenz festgestellten Bitfehlerverteilungen und Blockfehlerraten wie folgt ausgewertet:

Falls alle überprüften Frequenzen nur burstartig oder nur gleichförmig verteilte Bitfehler aufweisen, was gleichbedeutend damit ist, daß bei allen Frequenzen Empfangssignalstörungen durch Mehrwegeempfang, Interferenz oder Rauschen vorliegen, werden die zugehörigen Blockfehlerraten miteinander verglichen, wobei diejenige Frequenz mit der geringsten Blockfehlerrate als optimale Empfangsfrequenz ausgewählt wird. Der Tuner des Empfängers - bzw. im Fall des zwei Tuner aufweisenden Empfängers der erste Tuner - wird dann auf diese ausgewählte Frequenz abgestimmt, sofern nicht die bereits eingestellte Empfangsfrequenz mit der ausgewählten Frequenz identisch ist.

Für den Fall, daß die überprüften Frequenzen unterschiedliche Störungen, also sowohl durch Rauschen als auch durch Mehrwegeempfang verursachte Bitfehler aufweisen, werden zunächst diejenigen Frequenzen vorselektiert, welche im wesentlichen durch Rauschen und nicht durch Mehrwegeempfang gestört sind, d.h., welche im wesentlichen gleichförmig verteilte Fehler aufweisen. Um stark verrauschte Signal auszuschließen, können nur solche Frequenzen vorselektiert werden, bei deren RDS-Datensignal eine maximal zulässige Blockfehlerrate nicht überschritten wird. Anschließend werden die vorselektierten Frequenzen hinsichtlich ihrer festgestellten Blockfehlerrate miteinander verglichen, wobei wiederum diejenige Frequenz mit der geringsten Blockfehlerrate als optimale Empfangsfrequenz ausgewählt wird.

Die vorstehend Auswahl der optimalen Frequenz kann bei ausreichend langem Meßintervall je alternativer Sendefrequenz ohne Berücksichtigung der jeweiligen Empfangsfeldstärke erfolgen. Insbesondere bei geringeren Meßintervallen kann zusätzlich die Empfangsfeldstärke für die Auswahl herangezogen werden, wobei die Gewichtung zwischen Empfangsfeldstärke einerseits und Signalverzerrungen andererseits empirisch festgelegt werden kann.

Die alternativen Frequenzen können mit Hilfe des PI-Codes oder des AF-Codes oder unter Verwendung und gegebenenfalls Ergänzung - im Falle von Mehrdeutigkeiten oder unvollständiger Übertragung - beider Codes festgestellt werden. Der PI-Code identifiziert Frequenzen, auf welchen dasselbe Programmsignal empfangbar ist. Durch Vergleich des PI-Codes beim Sendersuchlauf kann eine eindeutige Zuordnung von momentaner Empfangsfrequenz und dessen alternative Frequenzen erfolgen. Diese Zuordnung kann aus dem AF-Code unmittelbar entnommen werden. Falls der AF-Code nicht im RDS-Datensignal übertragen wird oder falls der AF-Code fehlerbehaftet ist, können daher die alternativen Frequenzen auch aus dem PI-Code abgeleitet bzw. ergänzt werden.

Mit Hilfe des erfindungsgemäßen Verfahrens ist es möglich, die mit der Einführung des RDS-Systems und der darin enthaltenen alternativen Frequenzen angestrebten Vorteile eines stets optimalen Empfangs von Rundfunkempfängern (sowohl von mobilen als auch von ortsfesten Rundfunkempfängern) erstmals durch ein völlig neuartiges Konzept zur Ermittlung der optimalen Empfangsqualität zu verwirklichen. Dabei lassen sich mit Hilfe des RDS-Datensignals die Probleme des Mehrwegempfangs des Nutzsignals in überraschender Weise wesentlich verringern.

Bei dem erfindungsgemäßen Verfahren gemäß einer weiteren Ausführungsform ist vorgesehen, bei der Folge von einzelnen Listen, die in den digitalen Informationen des RDS-Datenstroms enthalten sind und die ihrerseits den jeweiligen Sendern einer Senderkette zugeordnete oder auf diese jeweiligen Sender optimierte alternativer Frequenzen enthalten, die in oder zu jeder Liste vorgesehene Betriebsfrequenz des zugehörigen Senders nicht nur am Anfang der Liste zu übertragen, sondern zusätzlich vor jeder einzelnen alternativen Frequenz der betreffenden Liste, so daß jede alternative Frequenz mit der Betriebsfrequenz "adressiert" ist. Jede Liste besteht somit aus einer Folge digitaler Informationsblöcke, wobei jeder Block aus zwei Informationen besteht. Eine dieser Informationen jedes Blockes ist (bis auf ganz spezielle Ausnahmen) die Betriebsfrequenz des der jeweiligen Liste zugeordneten Senders. Falls daher ein Teil der Liste inkorrekt übertragen oder empfangen wird, können die korrekt empfangenen alternativen Frequenzen infolge ihrer Paarung mit der Betriebsfrequenz eindeutig dem zugehörigen Sender zugeordnet werden und in dessen Liste empfangsseitig einsortiert werden. Da es unwahrscheinlich ist, daß in einer betrachteten Liste stets derselbe Informationsblock gestört ist, kann aus zwei oder drei aufeinanderfolgend empfangenen gestörten Listen desselben Senders die vollständige Liste empfangsseitig gespeichert werden.

Die vorstehend erläuterte Paarung jeder alternativen Frequenz mit der Betriebsfrequenz des der Liste zugeordneten Senders erhöht im Vergleich zu dem Verfahren gemäß der DE-C-34 32 848 die Anzahl der je Liste zu übertragenden Frequenzinformationen auf das Doppelte, wodurch die Zyklusdauer für jede Folge von Listen entsprechend vergrößert wird. Man könnte daher annehmen, daß die Empfangswahrscheinlichkeit und -sicherheit bei einer solchen verlängerten Zyklusdauer eher verschlechtert als verbessert wird. In der Tat wird für das eingangs erwähnte Matrixverfahren als Vorteil gegenüber dem Listenverfahren nach der DE-C-34 32 848 die geringere Zyklusdauer einer Matrix gegenüber einer Folge einzelner Listen geltend gemacht und hieraus eine höhere Empfangssicherheit abgeleitet.

Es muß daher für die Fachwelt überraschen, daß trotz der erheblichen Vergrößerung der Zyklusdauer der erfindungsgemäß übertragenen Folge von Listen die Empfangssicherheit entscheidend höher ist als beim Matrixverfahren und beim gattungsgemäßen Listenverfahren. Der nicht vorhersehbare Grund für diesen überraschenden Vorteil liegt darin, daß infolge der geschilderten Adressierung jeder alternativen Frequenz mit der Betriebsfrequenz auch bei äußert schlechten Empfangsverhältnis-sen noch eine sichere Zuordnung der korrekt empfangenen alternativen Frequenzen möglich ist, was bei den beiden anderen Verfahren nicht der Fall ist, so daß deren kürzere Zyklusdauer in solchen Empfangssituationen nichts nützt.

Weitere Merkmale, Vorteile und Einzelheiten der Erfindung werden nachstehend an drei Ausführungsbeispielen anhand der Zeichnungen näher erläutert. Dabei zeigen:
- Fig. 1: eine schematische Darstellung der von jedem Sender einer Senderkette abgestrahlten Folge von Listen alternativer Frequenzen, die zum empfangsseitigen Auswerten vorgesehen sind ,
- Fig. 2: zeigt ein Blockschaltbild eines Empfängers für ein Verfahren gemäß einem ersten Ausführungsbeispiel der Erfindung
- Fig. 3: zeigt ein Blockschaltbild eines Empfängers für ein Verfahren gemäß einem zweiten Ausführungsbeispiel der Erfindung

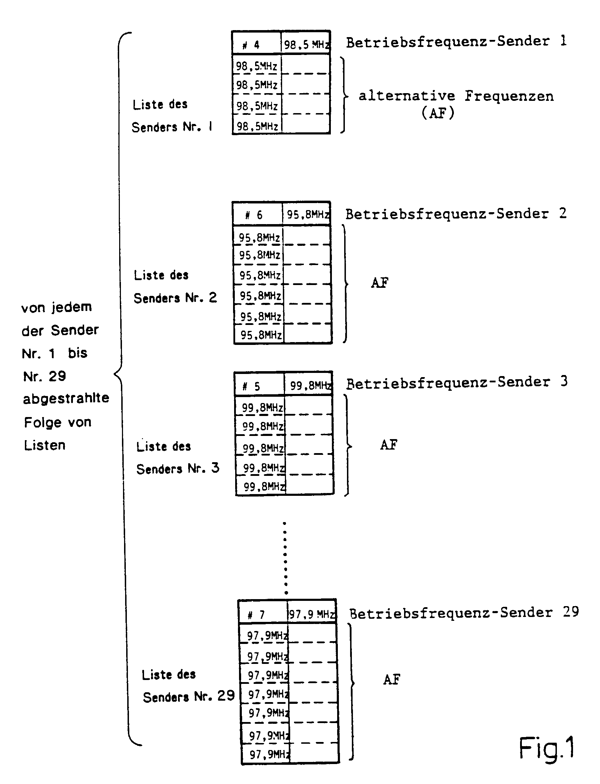

In Fig. 1 ist schematisch ein System von alternativen Listen dargestellt, das als zusätzliche Information eines Rundfunksenders übertragen wird. Im betrachteten Beispielsfall wird von einem Rundfunksignal ausgegangen, in welches ein Hilfsträger von 57 kHz eingefügt ist. Der Hilfsträger kann eine Amplitudenmodulation enthalten, welche eine Verkehrsfunkkennung zum Inhalt hat. Als Modulation bzw. als weitere Modulation ist dem Hilfsträger ein Datensignal aufgeprägt, welches in einer bestimmten , hier nicht näher interessierenden Weise codiert ist. Dieses Datensignal wird in übereinstimmender Form von sämtlichen Sendern einer Senderkette mit demselben Programm übertragen, beispielsweise von sämtlichen Sendern der Senderkette "Bayern 3" im Versorgungsbereich des Bayerischen Rundfunks (abgekürzt: BR). Das übereinstimmend übertragene Datensignal enthält unter anderem eine Folge von Listen alternativer Frequenzen für sämtliche Sender der Senderkette, im dargestellten Beispielsfall die Liste des Senders Nr. 1, die Liste des Senders Nr. 2, die Liste des Senders Nr. 3 bis zur Liste des Senders Nr. 29 für den Fall einer Senderkette mit 29 Sendern. Jede Liste ist auf den jeweiligen Sender speziell zugeschnitten und enthält die für diesen Sender vorgesehenen alternativen Frequenzen, also die Frequenzen derjenigen Sender, welche im Empfangsgebiet des betreffenden Senders alternativ auf demselben Programm empfangbar sind. Beispielsweise kann im Raum München das Programm "Bayern 3" alternativ von dem Sender "Wendelstein" oder dem Sender "Ismaning" empfangen werden. Ist der Empfänger auf den Sender Wendelstein abgestimmt, so kann bei einer Empfangsverschlechterung, z.B. infolge Mehrwegeempfangs, der Empfänger aufgrund seiner Kenntnis über die "Alternative" Ismaning kurzzeitig auf den Empfänger Ismaning abstimmen und dessen Empfangsfeldstärke überprüfen; ist letztere besser, wird auf den Sender Ismaning umgeschaltet, wobei dieser Prüfvorgang für den Zuhörer praktisch nicht hörbar ist.

Jede Liste besteht aus einer Folge von digitalen Informationsblöcken, welche in Fig. 1 als horizontale Zeilen innerhalb der Liste angedeutet sind. Jeder Informationsblock besteht aus einem Paar von Informationen, wie durch die vertikale Trennung der Liste in eine linke und eine rechte Hälfte angedeutet ist. Der erste, als "Header" bezeichnete Block jeder Liste enthält in der linken Blockhälfte die Anzahl der alternativen Frequenzen innerhalb der betreffenden Liste. Im Falle der Liste des Senders Nr. 1 mit vier alternativen Frequenzen enthält der Header die Zahl # 4, im Falle der Liste des Senders Nr. 29 mit sieben alternativen Frequenzen enthält der Header die Zahl #7. In der rechten Blockhälfte enthält der Header jeder Liste die Betriebsfrequenz des der Liste zugeordneten Senders. Im Falle der Liste des Senders Nr. 1 mit der Betriebsfrequenz 98,5 MHz ist in der rechten Hälfte des Headers die Frequenzinformation 98,5 MHz enthalten. Im Falle der Liste des Senders Nr. 29 mit der Betriebsfrequenz 97,9 MHz wird im Header die Frequenzinformation "97,9 MHz" übertragen.

Insoweit besteht übereinstimmung mit dem Verfahren gemäß der DE-C-34 32 848. Dort werden in den auf den Header folgenden Blöcken jeder Liste zwei alternative Frequenzen übertragen, so daß im Falle der Liste Nr. 1 mit vier alternativen Frequenzen auf den Header zwei Blöcke mit 2*2 = 4 alternativen Frequenzen folgen.

Demgegenüber wird im vorliegenden Beispiel in jedem auf den Header folgenden Block die der Liste zugeordnete Betriebsfrequenz übertragen, und zwar zusammen mit einer alternativen Frequenz. Diese Paare enthalten somit die Betriebsfrequenz als Adresse für die jeweilige alternative Frequenz, was den schon erwähnten Vorteil hat, daß die Empfangssicherheit drastisch erhöht wird, obwohl die Anzahl der je Liste erforderlichen Blöcke, die auf den Header folgen, verdoppelt wird.

Im Fall der Liste des Senders Nr. 1 müssen nach dem Header statt zwei Blöcke wie gemäß DE-PS 34 32 848 nunmehr vier Blöcke übertragen werden, was eine entsprechende Erhöhung der Übertragungszeit für die Folge von 29 betrachteten Listen mit sich bringt. Da diese übertragungszeit gleich der Zyklusdauer jeder Folge von Listen ist, könnte man glauben, daß infolge dieser Verlängerung der Zyklusdauer die Empfangssicherheit bei übertragungsstörungen verschlechtert wird. Diese Vermutung ist jedoch, wie schon dargelegt, falsch, so daß der überraschende Effekt zu verzeichnen ist, daß bei diesem Beispiel trotz Verlängerung der Zyklusdauer die Empfangssicherheit deutlich gegenüber dem Listenverfahren und dem Matrixverfahren vergrößert ist.

Im Falle von Sendern, deren Betriebsfrequenz nicht im 100 kHz-Raster liegt, sondern dazwischen (sog. Offset-Frequenzen), z.B. 92,85 MHz beträgt, wird im Header der betreffenden Liste nicht die Betriebsfrequenz, sondern eine Sonderinformation, ein sog. "Fillercode" gemäß dem eingangs erwähnten Dokument der Europäischen Rundfunkunion übertragen. In dem darauf folgenden Block wird zuerst die Offset-Frequenz, z.B. "92,85 MHz" und dann die "Quasi-Betriebsfrequenz", z.B. "92,8 MHz" übertragen. Diese Quasi-Betriebsfrequenz wird in den folgenden Blöcken an erster Stelle als Adresse für die alternativen Frequenzen übertragen.

Eine weitere Abweichung von der in der Zeichnung dargestellten übertragungsregel für die einzelnen Listen ergibt sich, falls eine der alternativen Frequenzen eine Offset-Frequenz ist. In diesem Falle wird im entsprechenden Block anstelle der Betriebsfrequenz die Offset-Frequenz der alternativen Frequenz übertragen, und zwar zusammen mit der "Quasi-alternativen Frequenz", die im 100 kHz-Raster liegt.

Zur Identifizierung von alternativen Frequenzen solcher Sender, welche im Rahmen von Regionalprogrammen für einige Zeit eines Sendetages oder einer Sendewoche aus der zugeordneten Senderkette herausgeschaltet werden, z.B. Sender, die von 6.00 bis 12.00 Uhr das Programm "Bayern 3", von 12.00 bis 13.30 Uhr das Regionalprogramm "Neues aus Schwaben" und von 13.30 bis 24.00 Uhr wieder das Programm "Bayern 3" übertragen, kann es günstig sein, im zugeordneten Block die Reihenfolge von Betriebsfrequenz und alternativer Frequenz zu vertauschen, also zuerst die alternative Frequenz und dann die Adresse "Betriebsfrequenz" im Block zu übertragen.

Jede Liste ist auf den jeweiligen Sender speziell zugeschnitten und enthält entsprechend der Vereinbarung innerhalb der Europäischen Rundfunk-Union maximal 25 Frequenzen, im Regelfall jedoch erheblich weniger. Am Beginn jeder Liste steht die Betriebsfrequenz des zugehörigen Senders, d.h. bei der Liste des Senders Nr. 1 steht am Anfang die Betriebsfrequenz des Senders Nr. 1, z.B. 98,5 MHz. Wie erwähnt, wird die dargestellte Folge von 29 Listen von jedem Sender der Senderkette als Datensignal übertragen.

Der Empfänger empfängt und decodiert das übertragene Datensignal, d.h. die Folge von Listen alternativer Frequenzen. Um die für den momentan abgestimmten Sender gültige Liste aus der empfangenen Listenfolge zu selektieren, braucht der Empfänger lediglich die erste Frequenz jeder Liste mit der momentanen Abstimmfrequenz zu vergleichen, was selbst bei 29 Listen in äußerst kurzer Zeit durchführbar ist. Diese Selektion kann entweder im On-Line-Betrieb oder im Off-Line-Betrieb erfolgen, d.h., ohne oder mit Zwischenspeicherung der empfangenen Folge von Listen. In einem bevorzugten Ausführungsbeispiel wird die selektierte Liste in jedem Falle gespeichert.

Bei der Verarbeitung der empfangenen und ggf. zwischengespeicherten Folge von Listen selektiert der Empfänger diejenige Liste, deren erste Frequenz (gleich Betriebsfrequenz des zugeordneten Senders) mit der momentanen Abstimmfrequenz übereinstimmt. Stimmt die erste Frequenz mehrerer Listen mit der eingestellten Betriebsfrequenz überein, so müssen alle diese Listen selektiert werden. Ausschließlich die selektierte(n) Liste(n) wird (werden) für die anschließende Optimierung der Abstimmung verwendet.

Dieser Abstimmvorgang erfolgt entweder durch einen entsprechenden Befehl des Zuhörers oder automatisch, wenn beispielsweise der momentan empfangene Sender nicht mehr empfangswürdig ist. Bei dem Abstimmvorgang stimmt der Empfänger selbsttätig auf die in der (den) selektierten Liste(n) aufgeführten alternativen Frequenzen ab und selektiert diejenige alternative Frequenz, welche den bestmöglichen Empfang bietet. Mit Hilfe des übertragenen Datensignals RDS läßt sich auch bei Senderketten mit mehr als der festgelegten maximalen Anzahl von alternativen Frequenzen eine rasche Optimierung der Abstimmung mobiler Empfänger durchführen, ohne daß eine Ausfilterung und Neueinspeisung von Frequenzlisten am Standort von Tochtersendern erforderlich wird.

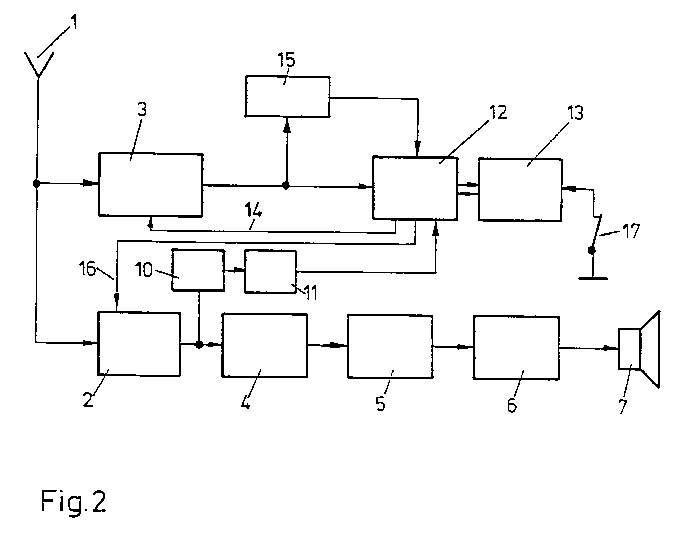

Fig. 2 zeigt zeigt ein Blockschaltbild eines Empfängers für ein Verfahren gemäß einem ersten Ausführungsbeispiel der Erfindung. Dabei wird auf das anhand von Fig. 1 beschriebene System Bezug genommen, wenngleich es bei dem ersten Ausführungsbeispiel nicht darauf ankommt, daß die zusätzlichen Informationen in digitaler Form übertragen werden.

Die mit einer Antenne 1 empfangenen, zusätzliche Daten enthaltenden Rundfunksignale werden einerseits einem Tuner 2 und andererseits einem Tuner 3 zugeführt. Der Tuner 2 ist Teil eines Rundfunkempfangsgeräts mit einem Zwischenfrequenzverstärker 4 für die vom Tuner gelieferte Zwischenfrequenz sowie mit einem Demodulator 5 für die Rückgewinnung der Niederfrequenzsignale und mit einem Verstärker 6 für die Niederfrequenzsignale, sowie mit einem Lautsprecher 7 für die akustische Wiedergabe. An den Signalweg, z.B. an den Ausgang des Tuners 2, ist eine Schaltung 10 zur Selektion des 57 kHz-Trägers angeschlossen, der mit einer Schaltung 11 zur Rückgewinnung der Daten verbunden ist. Die Daten werden einem Speicher 12 zugeführt. In diesen Speicher 12 werden ständig die alternativen Frequenzen (AF) des vom Tuner 2 empfangenen Betriebsfrequenzsenders eingelesen.
Der Tuner 3 dient zur ständigen Abtastung der vom Tuner 2 empfangbaren Frequenzbereiche. Seine hoch- oder zwischenfrequenten Ausgangssignale werden ebenfalls dem Speicher 12 zugeführt. Die vom Tuner 3 abgetasteten Frequenzen werden ständig mit den entsprechend gespeicherten Frequenzen verglichen, um ein Maß für den momentan am besten zu empfangenden Sender zu schaffen. Die vom Tuner 3 jeweils einzustellende Frequenz wird vom Speicher 12 mittels eines Mikroprozessors 13 über eine Leitung 14 bestimmt und der Tuner 3 entsprechend abgestimmt.

Eine Schaltung 15 dient zur Messung der Feldstärke des jeweils empfangenen Senders. Sobald die Feldstärkemessung ergibt, daß die Signale eines anderen Senders eine größere Feldstärke haben als der vom Tuner 2 eingestellte Betriebsfrequenzsender, wird der Tuner 2 über eine Leitung 16 auf den Sender momentan größerer Feldstärke umgestellt.

Bei der soweit beschriebenen Schaltung ist es möglich, daß aufgrund von Interferenzen, z.B. solchen, die durch Reflexionen verursacht werden, Verzerrungen des akustisch wiedergegebenen Audiosignals auftreten. Solche Interferenzen treten meist in der Nähe sehr starker Sender auf. Auch kann durch eine große Feldstärke am momentanen Empfangsort eine übersteuerung des Empfängers eintreten, durch die die akustische Wiedergabe verzerrt wird.

Bei bekannten Verfahren, beispielsweise nach der DE-C-34 48 043, wird nach Auswahl eines Senders eine vollautomatische Abstimmung ohne Mitwirkung des Benutzers auf denjenigen Sender mit demselben Programm ermöglicht, welcher am momentanen Empfängerstandort am besten empfangbar ist,d.h. die größte Feldstärke liefert.

Zu diesem Zweck wird jeder Sender nicht nur seine eigene Liste, sondern sequentiell auch die Listen aller weiteren Sender derselben Senderkette ausstrahlen, wobei die Betriebsfrequenzen der einzelnen Sender jeweils am Anfang der einzelnen Listen stehen. Der Empfänger kann so nach erfolgtem Empfang aller Listen aufgrund seiner momentanen Abstimmfrequenz die zu dem momentan eingestellten Sender gehörende Liste selektieren, indem er die Abstimmfrequenz mit der ersten Frequenz jeder Liste innerhalb der Listenfolge vergleicht. Ferner erkennt der Empfänger auch die alternativen Frequenzen, auf denen er bei Verlassen des Versorgungsbereichs des momentan eingestellten Senders das gleiche Programm weiter empfangen kann, ohne daß er die alternativen Frequenzen der übrigen Listen prüfen muß. Das Umschalten auf einen anderen Sender derselben Senderkette kann auf diese Weise in der Regel sehr rasch durchgeführt werden.

Doch gerade beim Empfang von Sendern mit großer anstehender Feldstärke kann die akustische Wiedergabe verzerrt sein kann. Das kann beispielsweise auf einer Übersteuerung infolge zu starker Empfangsfeldstärke beruhen oder auf Interferenzerscheinungen durch Reflexionen.

Bei dem vorliegenden Ausführungsbeispiel gemäß der Erfindung ist daher vorgesehen, eine Sendereinstellung unter Beibehaltung der automatischen Umschaltung auf andere dasselbe Programm ausstrahlende Sender zu ermöglichen, bei der akustische Verzerrungen bei der Wiedergabe weitgehend vermieden oder verringert werden.

Durch einen Schalter 17 wird in dem Mikroprozessor 13 ein Schaltzustand erzeugt, bei dem nicht der stärkste Sender, sondern ein schwächerer Sender, insbesondere der zweitstärkste Sender für den Vergleich mit dem jeweils eingestellten Betriebsfrequenzsender herangezogen wird.

Durch zusätzliche Ausbildung des Schalters 17 als Rückstelltaste wird erreicht, daß die Einstellung des Gerätes auf Sender kleinerer als der momentanen größten Feldstärke widerrufen werden kann, wenn die Nahzone oder Störzone des Senders verlassen wird. Ein mehrmaliger Schaltvorgang wird so erleichtert möglich. Die Wirkung des Schalters 17 auf den Mikroprozessor 13 kann auch so ausgelegt sein, daß durch mehrmaliges kurzes Antippen von Schalter 17 alle Sender entsprechend der gespeicherten alternativen Liste nacheinander mit fallender Feldstärke einstellbar sind. Durch ein längeres Betätigen von Schalter 17 z.B. über mehrere Sekunden kann der Rücksetzvorgang ausgelöst werden.

Der Tuner 3 kann in Fig. 2 eine andere Ausführung haben als der Tuner 2, da seine eigentliche Aufgabe nur das Abtasten des Frequenzbandes zur Kontrolle evtl. stärkerer Sender ist. Eine Signalqualität muß also nicht erreicht werden.

Es ist auch möglich, bei Verwendung von nur einem Tuner eine Feldstärkenumschaltung in der beschriebenen Form durchzuführen, wobei allerdings für den Benutzer während des Abfragevorganges Sender mit geringeren Feldstärken empfangen werden können.

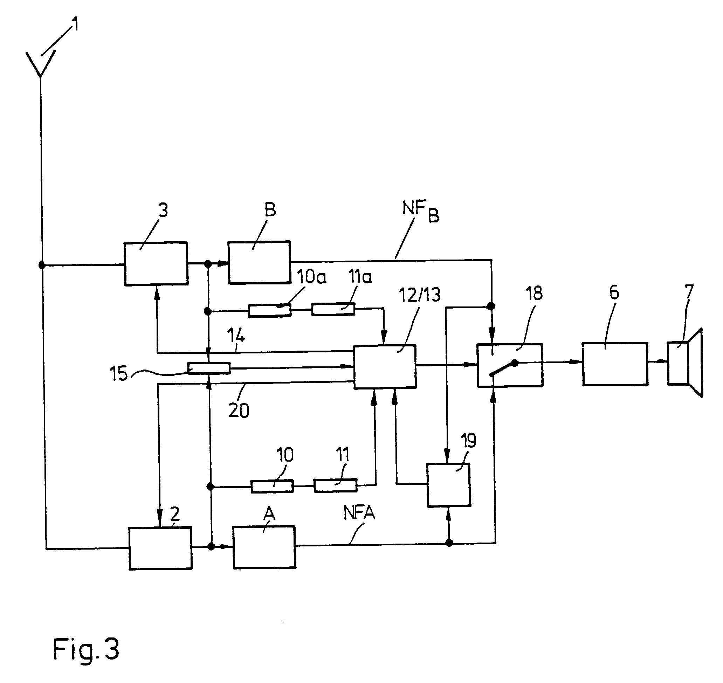

Fig. 3 zeigt in einem zweiten Ausführungsbeispiel der Erfindung eine Abwandlung der in Fig. 2 dargestellten Schaltung, bei der zwei gleichwertige Tuner 2 und 3 in zwei getrennte Empfängerzüge A, B eingeschaltet sind, die jeder ein NF-Ausgangssignal NF_{A}, NF_{B} zu einem NF-Schalter 18 liefern, der jeweils eines der beiden Signale zum NF-Verstärker 6 und Lautsprecher 7 weiterleitet. Aus dem Tuner 2 werden die Datensignale (z.B. aus dem RDS-Datenstrom) mittels der Auswahlschaltung 10, 11 selektiert und dem Speicher 12 mit Mikroprozessor 13 zugeführt. Aus dem Tuner 3 werden ebenfalls die Datensignale selektiert und dem Speicher 12 mit Mikroprozessor 13 zugeführt. Tuner 2 ist durch manuelle bzw. willkürliche Eingabe abstimmbar. Tuner 3 wird durch den Speicher 12 bzw. den Mikroprozessor 13 über Leitung 14 entsprechend der gespeicherten alternativen Liste abgefragt.

Die Erkennung des jeweiligen Senders mit der größten Feldstärke erfolgt in Schaltung 15 durch Vergleich der empfangenen Signale von Tuner 2 und Tuner 3. Für den Fall, daß mit dem Tuner 2 nicht der Sender mit der optimal zu empfangenden Feldstärke eingestellt ist, übernimmt der Tuner 3 diesen feldstärksten Sender, und dessen NF-Ausgangssignal NF_{B} wird über den Schalter 18 an den NF-Verstärker 6 und Lautsprecher 7 gelegt.

In diesem Schaltzustand wird Tuner 2 über Leitung 20 vom Mikroprozessor 12/13 entsprechend der in den alternativen Listen gespeicherten Frequenzen abgefragt.

Die NF-Signale NF_{A} und NF_{B} werden einer Schaltung 19 zum Vergleich der Modulation beider Signale zugeführt. In dieser Modulationsvergleichsschaltung wird der Modulationsinhalt des mit der größten Feldstärke eingestellten Senders mit dem Modulationsinhalt der aus der alternativen Liste ausgewählten Sender verglichen. Zweckmäßigerweise erfolgt dieser Vergleich jeweils mit dem zweitstärksten Sender aus der Liste.

Der Vergleich kann durch direkten Vergleich des zeitlichen Verlaufes der Niederfrequenzspannung oder durch Vergleich der Hüllkurven der beiden NF-Signale geschehen. Zeigt dabei der Sender mit der größeren Feldstärke durch Reflektionseinwirkung Modulationseinbrüche oder Modulationsvertiefungen und Abkappungen der NF durch übersteuerung, wird automatisch Schalter 18 durch den Mikroprozessor 12/13 auf den zweitstärksten Sender umgeschaltet, so daß die Verzerrungen für den Nutzer nicht erkennbar sind. Sind beide Signale identisch, bleibt der Sender mit der jeweils größeren Feldstärke angeschaltet. In der Folge kann der Schalter 18 ständig von dem gerade wirksamen Empfänger A, B auf den jeweils anderen Empfänger B, A umgeschaltet werden in Abhängigkeit von der Steuerung des Mikroprozessors. Lediglich bei manueller oder anderer Eingabe durch den Nutzer wird Tuner 2 wieder zunächst bevorrechtigt, um dann weiter der automatischen, RDS-gesteuerten Betriebsweise unterworfen zu werden.

## Patentansprüche

1. Verfahren zum empfangsseitigen Auswerten von innerhalb eines Rundfunksignals übertragenen digitalen Informationen, z.B. AF-Code und/oder PI-Code in einem RDS-Datensignal, aus welchen unmittelbar entnehmbar ist oder herleitbar ist, auf welchen alternativen Sendefrequenzen das Programmsignal der momentanen Empfangsfrequenz ebenfalls empfangbar ist, bei dem
a) zu der momentanen Empfangsfrequenz alternative Sendefrequenzen durch Auswertung des AF-Codes und/oder des PI-Codes und/oder vergleichbarer Codes festgestellt werden,
b) ein Empfangsteil des Empfängers auf eine oder nacheinander auf mehrere alternative Frequenzen kurzzeitig abgestimmt wird und die Empfangsqualität für jede dieser alternativen Frequenzen sowie für die momentane Empfangsfrequenz festgestellt wird,
c) als optimale Empfangsfrequenz diejenige Frequenz gewählt wird, welche die bestmögliche Empfangsqualität bietet, **dadurch gekennzeichnet,** daß die Empfangsqualität dahingehend bewertet wird, daß bei den empfangenen digitalen Informationen - z.B. beim empfangenen RDS-Datensignal - festgestellte Bitfehler als Maß zur Fehlerkorrektur und/oder zur Qualitätsbewertung für festzustellende Programmsignalverzerrungen allein oder zusätzlich zu einem von der Empfangsfeldstärke abgeleiteten Maß herangezogen werden.

2. Verfahren nach Anspruch 1, **dadurch gekennzeichnet,** daß die Bitfehler im RDS-Datensignal dahingehend zur Bewertung der Programmsignalverzerrungen herangezogen werden, daß
a) bei burstartig auftretenden Bitfehlern Störungen durch Mehrwegeempfang oder Interferenz vorliegen;
b) bei gleichförmig verteilten Fehlern Störungen durch Rauschen vorliegen;
c) der Grad aller Störungen aus der Blockfehlerrate des in Blöcken strukturierten RDS-Datensignals abgeleitet wird,
und wobei aus den für jede alternative Sendefrequenz sowie für die momentane Empfangsfrequenz ermittelten Bitfehlern folgende Auswahlentscheidungen abgeleitet werden:
d) Falls alle überprüften Frequenzen im wesentlichen nur burstartig oder nur gleichförmig verteilte Bitfehler aufweisen, werden sie hinsichtlich ihrer Blockfehlerrate miteinander verglichen, wobei diejenige Frequenz mit der geringsten Blockfehlerrate für die Empfängerabstimmung selektiert wird;
e) falls die überprüften Frequenzen unterschiedliche Bitfehlerverteilungen aufweisen, werden zunächst diejenigen Frequenzen vorselektiert, welche im wesentlichen nur gleichförmig verteilte Bitfehler aufweisen - gegebenenfalls abhängig davon, daß bei diesen Frequenzen eine festgelegte, maximal zulässige Blockfehlerrate nicht überschritten wird -, und anschließend werden die vorselektierten Frequenzen hinsichtlich ihrer Blockfehlerrate miteinander verglichen, wobei diejenige vorselektierte Frequenz mit der geringsten Blockfehlerrate für die Empfängerabstimmung selektiert wird.

3. Verfahren nach Anspruch 1 oder 2, **dadurch gekennzeichnet,** daß die digitalen Informationen eine Folge von einzelnen, den jeweiligen Sendern einer Senderkette zugeordneten oder auf diese jeweiligen Sender optimierten Listen alternativer Frequenzen enthalten, wobei die Betriebsfrequenzen der einzelnen Sender der Senderkette in den einzelnen Listen enthalten sind, und daß die empfangenen digitalen Informationen einer Fehlerkorrektur unterzogen werden und eine nach Maßgabe der fehlerkorrigierten digitalen Informationen erfolgende Adressierung der alternativen Frequenzen aufgrund der in oder zu jeder Liste - gegebenenfalls mehrfach - übertragenen Senderbetriebsfrequenz vorgenommen wird.

4. Verfahren nach einem der Ansprüche 1 bis 3, **dadurch gekennzeichnet,** daß in den digitalen Informationen enthaltene, jeweils zusammen mit einer zugehörigen Senderbetriebsfrequenz als Frequenzpaare übertragene alternative Frequenzen nach Maßgabe der ihnen jeweils unmittelbar vorangehenden oder folgenden Senderbetriebsfrequenz adressiert und gegebenenfalls gespeichert werden.

5. Verfahren nach einem der Ansprüche 1 bis 4 als Abstimmhilfe beim Rundfunkempfang, bei dem die digitalen Informationen eine Folge von einzelnen, den jeweiligen Sendern einer Senderkette zugeordneten oder auf diese jeweiligen Sender optimierten Listen alternativer Frequenzen enthalten, **dadurch gekennzeichnet,** daß bei übertragung jeder Liste als Folge digitaler Blöcke mit jeweils zwei digitalen Informationen je Block in der Regel
a) im ersten Block jeder einzelnen Liste eine Information über die Anzahl der alternativen Frequenzen der jeweiligen Liste sowie die Betriebsfrequenz des der jeweiligen Liste zugeordneten Senders, und
b) in den restlichen Blöcken jeder einzelnen Liste jeweils die Betriebsfrequenz des der jeweiligen Liste zugeordneten Senders sowie die alternative Frequenz übertragen werden.

6. Verfahren nach Anspruch 5, **dadurch gekennzeichnet,** daß empfangsseitig die in den Blöcken jeder Liste übertragene Betriebsfrequenz zur Zuordnung der alternativen Frequenzen zu der betreffenden Liste im Sinne einer eindeutigen, störsicheren Adressierung benutzt wird.

7. Verfahren nach einem der Ansprüche 1 bis 6, **dadurch gekennzeichnet**, daß von den empfangenen alternativen Frequenzen aller Frequenzlisten nur diejenigen alternativen Frequenzen gespeichert und/oder für die Abstimmung verwendet werden, deren jeweils zugeordnete Betriebsfrequenz mit der momentan eingestellten Empfangsfrequenz des Rundfunkempfängers übereinstimmt.

8. Verfahren nach einem der Ansprüche 1 bis 7, **dadurch gekennzeichnet**, daß empfangsseitig die den momentan bestmöglichen Empfang bietende alternative Frequenz dahingehend überprüft wird, ob sie eine akustisch akzeptable Wiedergabe ermöglicht, und daß für den Fall, daß die überprüfte alternative Frequenz nur eine akustisch verzerrte Wiedergabe ermöglicht, eine andere alternative Frequenz gewählt wird.

9. Verfahren nach einem der Ansprüche 1 bis 8, **dadurch gekennzeichnet**, daß zur Wahl einer anderen alternativen Frequenz manuell und/ oder von einem Signal einstellbare Mittel verwendet werden, wobei das genannte Signal - gegebenenfalls auch unterschiedlich gewichtet - sowohl aus dem Vergleich empfangener Feldstärken als auch aus dem Vergleich von den Feldstärken zugeordneten niederfrequenten Verzerrungen abgeleitet ist.

10. Verfahren nach einem der Ansprüche 1 bis 9**, dadurch gekennzeichnet**, daß die alternativen Frequenzen durch Auswerten des in dem digitalen RDS-Datensignal enthaltenen Codes für die Programm-Identifikation (PI-Code) festgestellt werden, wobei das Empfangsteil einen Sendersuchlauf durchführt und die PI-Codes der auf den einzelnen Senderfrequenzen empfangenen RDS-Datensignale dahingehend verglichen werden, daß gleiche PI-Codes diejenigen Frequenzen identifizieren, auf welchen dasselbe Programmsignal empfangbar ist.

## Claims

1. A method for the receiver end analysis of items of digital information transmitted in a broadcast signal, e.g. AF-code and/or PI-code in an RDS data signal, from which it is directly obtainable or is derivable at which alternative transmitter frequency the programme signal of the present receiving frequency is receivable, in which
a) transmitter frequencies alternative to the present receiving frequency are determined by analysis of the AF-code and/or the PI-code and/or comparable code,
b) a reception part of the receiver is temporarily tuned to one or successively to more alternative frequencies and the reception quality is determined for each of these alternative frequencies as well as for the present receiving frequency,
c) there is selected as the optimal receiving frequency, that frequency which offers the best possible reception quality, characterised in that the reception quality is assessed to the effect that, with the received digital information - e.g. with the received RDS data signal - there are used determined bit errors as a measure for the error correction and/or for the quality assessment for programme signal distortions to be determined, either alone or in addition to a measure derived from the received field strength.

2. A method according to claim 1, characterised in that the bit errors in the RDS data signal are used to assess programme signal distortions inasmuch as
a) disturbances due to multipath reception of interference are present in the case of bit errors occurring in the form of bursts;
b) disturbances due to noise are present in the case of uniformly distributed errors;
c) the degree of all the disturbances is derived from the block error rate of the RDS data signal structured in blocks,
and wherein the following selection decisions are derived from the bit errors determined for each alternative transmitting frequency and for the present receiving frequency:
d) if all the checked frequencies have bit errors which substantially are distributed only in the form of bursts or only uniformly, they are compared with one another in respect of their block error rate, where the frequency with the lowest block error rate is selected for the receiver tuning;
e) if the checked frequencies have different bit error distributions, initially those frequencies which have substantially only uniformly distributed bit errors are preselected - optionally in dependence upon the fact that at these frequencies a specified, maximum permissible block error rate is not exceeded - and then the preselected frequencies are compared with one another in respect of their block error rate, where the preselected frequency with the lowest block error rate is selected for the receiver tuning.

3. A method according to claim 1 or 2, characterised in that the digital information contains a sequence of individual lists of alternative frequencies assigned to the respective transmitters of a transmitter chain or optimised to these respective transmitters, wherein the operating frequencies of the individual transmitters of the transmitter chain are contained in the individual lists, and in that the received items of digital information are subjected to error correction and there is performed an addressing of the alternative frequencies, carried out in accordance with the error-corrected items of digital information, on the basis of the transmitter operating frequency transmitted - optionally several times - in or with each list.

4. A method according to any one of claims 1 to 3, characterised in that, contained in the digital information, in each case together with a related transmitter operating frequency transmitted as frequency pairs alternative frequencies are addressed and optionally stored according to the transmitter operating frequency directly preceding or following them.

5. A method according to any one of claims 1 to 4 as a tuning aid in broadcast reception, wherein the items of digital information contain a sequence of individual lists of alternative frequencies assigned to the respective transmitters of a chain of transmitters or optimised in respect of these respective transmitters, characterised in that in the transmission of each list as a sequence of digital blocks with in each case two items of digital information per block, there are transmitted generally
a) in the first block of each individual list an item of information relating to the number of the alternative frequencies of the respective list and the operating frequency of the transmitter assigned to the respective list and
b) in the remaining blocks of each individual list the respective operating frequency of the transmitter assigned to the respective list and the alternative frequency.

6. A method according to claim 5, characterised in that at the receiving end the operating frequency transmitted in the blocks of each list is used to assign the alternative frequencies to the relevant list in terms of clearly defined, disturbance-free addressing.

7. A method as claimed in any one of claims 1 to 6, characterised in that of the relevant alternative frequencies of all lists of frequencies, only those alternative frequencies the respective assigned operating frequency of which is identical to the currently set receiving frequency of the broadcast receiver are stored and/or used for the tuning.

8. A method according to any one of claims 1 to 7, characterised in that at the receiving end the alternative frequency which offers the currently best possible reception is checked to determine whether it permits an acoustically acceptable reproduction, and that in the event that the checked alternative frequency only permits an acoustically distorted reproduction, a different alternative frequency is selected.

9. A method according to any one of claims 1 to 8, characterised in that for the selection of another alternative frequency manually and/or set by a signal there are employed means, whereby the said signal - optionally weighted differently - is derived from both the comparison of received field strengths and from the comparison of the low-frequency distortions associated with the field strengths.

10. A method according to any one of claims 1 to 9, characterised in that the alternative frequencies are determined by analysis of the code for the programme identification (PI-code) contained in the digital RDS data signal, wherein the receiver part performs a transmitter search and the PI-codes of the RDS data signals received at the individual transmitter frequencies are compared to identify similar PI-codes of those frequencies at which the same programme signal can be received.

## Revendications

1. Procédé pour l'analyse, côté réception, d'informations numériques transmises à l'intérieur d'un signal de radiodiffusion, p.ex. code AF et/ou code PI dans un signal de données RDS qui fournissent directement ou par déduction les fréquences alternatives permettant de recevoir également le signal de programme de la fréquence de réception actuelle, procédé selon lequel
a) des fréquences alternatives par rapport à la fréquence de réception actuelle sont détectées par l'analyse du code AF et/ou du code PI et/ou de codes comparables,
b) un élément de réception du récepteur est accordé brièvement sur l'une ou, successivement, sur plusieurs des fréquences alternatives, et où la qualité de réception est établie pour chacune desdites fréquences alternatives ainsi que pour la fréquence de réception actuelle,
c) la fréquence de réception optimale étant celle offrant la meilleure qualité de réception possible, procédé **caractérisé en ce** que la qualité de réception est évaluée de telle manière que les erreurs sur les bits constatées dans les informations numériques reçues - p.ex. dans le signal de données RDS reçu - sont prises en compte seules ou en complément à une grandeur déterminée à partir de l'intensité de champ reçue, comme grandeur pour la correction des erreurs et/ou l'évaluation de la qualité des distorsions du signal de programme à définir.

2. Procédé selon la revendication 1 **caractérisé en ce** que les erreurs sur les bits dans le signal de données RDS servent à évaluer les distorsions du signal de programme de la manière suivante :
a) les erreurs sur le bits apparaissant sous forme de giclée indiquent la présence de perturbations dues à la réception par voies multiples ou aux interférences ;
b) les erreurs sur les bits réparties de façon régulière indiquent la présence de perturbations dues au bruit ;
c) Le degré de toutes les perturbations est déterminé à partir du taux d'erreurs sur les blocs du signal de données RDS structuré par blocs,
sachant en outre que les critères de sélection ci-dessous sont déduites des erreurs sur les bits définies pour chaque fréquence d'émission alternative ainsi que pour la fréquence de réception actuelle :
d) Si toutes les fréquences contrôlées ne présentent pratiquement que des erreurs sur les bits par giclée ou que des erreurs sur les bits réparties régulièrement, elles seront comparées les unes avec les autres par rapport à leur taux d'erreurs sur les blocs, la fréquence présentant le plus faible taux d'erreurs sur les bits étant alors sélectionnée pour le réglage du récepteur ;
e) Si les fréquences contrôlées présentent essentiellement des erreurs sur les bits réparties de façon diverse, les fréquences ne présentant pratiquement que des erreurs sur les bits réparties de façon régulière sont d'abord présélectionnées - le cas échéant, en fonction du fait que leur taux d'erreurs sur les blocs ne dépasse pas une certaine limite admissible -, puis les fréquences présélectionnées sont comparées les unes aux autres par rapport à leur taux d'erreurs sur les blocs, la fréquence présélectionnée présentant le plus faible taux d'erreurs sur les blocs étant enfin choisie pour le réglage du récepteur.

3. Procédé selon l'une quelconque des revendications 1 ou 2 **caractérisé en ce** que les informations numériques contiennent une série de différentes listes de fréquence alternatives associées aux émetteurs respectifs d'une chaîne d'émetteur ou optimalisées par rapport à ces émetteurs respectifs, sachant que les fréquences de service des différents émetteurs sont comprises dans les différentes listes, et que les informations numériques reçues sont soumises à une correction des erreurs et qu'un adressage des fréquences alternatives, réalisé suivant les informations numériques corrigées, est effectué en fonction de la fréquence de service de l'émetteur transmise - éventuellement plusieurs fois - dans ou avec chaque liste.

4. Procédé selon l'une quelconque des revendications 1 à 3 **caractérisé en ce** que les fréquences alternatives contenues dans les informations numériques et transmises sous la forme de paires de fréquences appariées avec une fréquence de service d'émission correspondante, sont adressées en fonction de la fréquence de service d'émission qui les précède ou leur succède directement, avant d'être éventuellement stockées dans une mémoire.

5. Procédé selon l'une quelconque des revendications 1 à 4 servant d'aide au réglage de la réception radio, où les informations numériques contiennent une série de différentes listes de fréquences alternatives associées aux émetteurs respectifs d'une chaîne d'émetteurs ou optimalisées par rapport audits émetteurs, **caractérisé en ce** que la transmission de chaque liste sous la forme de blocs numériques comportant chacun deux informations numériques se fait, en règle générale, de telle manière que
a) une information concernant le nombre de fréquences alternatives de la liste concernée ainsi que la fréquence de service de l'émetteur associé à la liste en question soient transmises dans le premier bloc de chacune des listes, tandis que
b) la fréquence de service de l'émetteur affecté à la liste concernée ainsi que la fréquence alternative sont transmises dans les autres blocs de chacune des listes.

6. Procédé selon la revendication 5 **caractérisé en ce** que, la fréquence de service transmise dans les blocs de chaque liste est utilisée au niveau de la réception pour affecter les fréquences alternatives à la liste concernée dans l'intérêt d'un adressage précis et sûr quant aux perturbations.

7. Procédé selon l'une quelconque des revendications 1 à 6 **caractérisé en ce** que, parmi les fréquences alternatives reçues de toutes les listes de fréquences, seules les fréquences alternatives dont la fréquence de service qui leur est attribuée correspond à la fréquence de réception du récepteur radio, sont mises en mémoire et/ou utilisées pour le réglage.

8. Procédé selon l'une quelconque des revendications 1 à 7 **caractérisé en ce** que, côté réception, la fréquence alternative offrant la meilleure réception possible au moment donné, est contrôlée afin de déterminer si elle permet une reproduction acoustique acceptable, et caractérisé en outre en ce qu'une autre fréquence alternative est choisie si la fréquence alternative vérifiée ne permet qu'une reproduction acoustique distordue.

9. Procédé selon l'une quelconque des revendications 1 à 8 **caractérisé en ce** que la sélection d'une autre fréquence alternatives est effectuée à l'aide de moyens réglables manuellement ou par l'intermédiaire d'un signal, sachant que ledit signal - éventuellement de pondération différente - peut être déduit tant de la comparaison des intensités de champ reçues que de la comparaison des distorsions de basse fréquence associées auxdites intensités de champ.

10. Procédé selon l'une quelconque des revendications 1 à 9 **caractérisé en ce** que les fréquences alternatives sont déterminées par une analyse du code d'identification de programme (code PI) inclus dans le signal de données RDS, sachant que l'élément de réception effectue une procédure de recherche d'émetteurs et que les codes PI des signaux de données RDS reçus sur les différentes fréquences d'émetteurs sont comparés les uns avec les autres de telle manière que les mêmes codes PI identifient les fréquences permettant de recevoir le même signal de programme.
